# FASCICULE DE BREVET EUROPEEN

(11) **EP 3 625 822 B1**
(45) Date de publication et mention de la délivrance du brevet: **05.01.2022**
(21) Numéro de dépôt: 18734867.7
(22) Date de dépôt: 04.05.2018
(51) Int. Cl.: H01L 23/00, H01L 21/683, H01L 25/075

(54) **PROCÉDÉ DE FABRICATION D'UN DISPOSITIF D'AFFICHAGE ÉMISSIF À LED**
VERFAHREN ZUR HERSTELLUNG EINER EMISSIVEN LED-ANZEIGEVORRICHTUNG
METHOD OF MANUFACTURING AN EMISSIVE LED DISPLAY DEVICE

(30) Priorité: 09.05.2017 FR 1754045
(43) Date de publication de la demande: 25.03.2020
(73) Titulaire: Commissariat à l'Energie Atomique et aux Energies Alternatives, 75015 Paris (FR)
(72) Inventeur: ROBIN, Ivan-Christophe, 38000 Grenoble (FR); CAPLET, Stéphane, 38360 Sassenage (FR); CYRILLE, Marie-Claire, 38650 Sinard (FR); DELAET, Bertrand, 38190 Bernin (FR); GIROUD, Sophie, 38120 Saint-Egreve (FR)
(74) Mandataire: Cabinet Beaumont
(86) Numéro de dépôt international: PCT/FR2018/051137
(87) Numéro de publication internationale: WO 2018/206891

(56) Documents cités:
- EP-A1- 2 865 021
- EP-A2- 2 667 422
- WO-A2-2005/122706
- US-A1- 2007 231 826
- US-A1- 2007 231 961
- US-A1- 2014 191 246
- US-A1- 2016 155 892

## Description

La présente demande de brevet revendique la priorité de la demande de brevet français FR17/54045 Domaine

La présente demande concerne la réalisation d'un dispositif d'affichage d'images émissif à diodes électroluminescentes (LED), par exemple un écran de télévision, d'ordinateur, de smartphone, de tablette numérique, etc.

### Exposé de l'art antérieur

Il a déjà été proposé, dans la demande de brevet français n°1561421 déposée le 26 novembre 2015, un procédé de fabrication d'un dispositif d'affichage d'images comportant une pluralité de micropuces électroniques élémentaires disposées en matrice sur un même substrat de report. Selon ce procédé, les micropuces et le substrat de report sont fabriqués séparément. Chaque micropuce comprend un empilement d'une LED et d'un circuit de commande de la LED. Le circuit de commande comprend une face de connexion opposée à la LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont ensuite rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

US 2007/231961 A1 divulgue un procédé de transfert de puces sur un substrat de report par collage direct dont l'alignement est assisté par des plots magnétiques.

Il serait souhaitable de pouvoir améliorer au moins en partie certains aspects de ce procédé.

En particulier, du fait des dimensions relativement petites des micropuces, et étant donné que chaque micropuce comprend plusieurs plages de connexion électrique distinctes, l'alignement des plages de connexion électrique des micropuces sur les plages de connexion électrique correspondantes du substrat de report est relativement délicat à réaliser. Il serait souhaitable de pouvoir faciliter la mise en oeuvre de cet alignement et/ou améliorer la précision d'alignement obtenue.

### Résumé

Ainsi, un mode de réalisation selon l'invention prévoit un procédé de fabrication d'un dispositif d'affichage électronique tel que défini par la revendication 1, comprenant les étapes suivantes :
a) réaliser une pluralité de puces comprenant chacune :
   - une pluralité de plages de connexion électrique disposées sur une face de connexion de la puce, et
   - au moins un premier plot disposé au voisinage de la face de connexion de la puce ;
b) réaliser un substrat de report comprenant, pour chaque puce :
   - une pluralité de plages de connexion électrique disposées sur une face de connexion du substrat de report, et
   - au moins un deuxième plot disposé au voisinage de la face de connexion du substrat de report, l'un des premier et deuxième plots étant un aimant permanent et l'autre des premier et deuxième plots étant soit un aimant permanent soit en un matériau ferromagnétique ; et
c) fixer les puces sur le substrat de report par collage direct de façon à connecter électriquement les plages de connexion électrique de chaque puce aux plages de connexion électrique correspondantes du substrat de report, en utilisant la force d'aimantation entre les premiers et deuxièmes plots pour aligner les plages de connexion électrique des puces sur les plages de connexion électrique correspondantes du substrat de report.

Selon un mode de réalisation, dans chaque puce, le premier plot débouche du côté de la face de connexion de la micropuce.

Selon un mode de réalisation, dans chaque puce, le premier plot est enterré sous la face de connexion de la puce.

Selon l'invention, dans chaque puce, la face de connexion de la puce est plane, les plages de connexion électrique de la puce affleurant au niveau d'une face externe d'une couche de passivation de la puce.

Selon un mode de réalisation, les deuxièmes plots débouchent du côté de la face de connexion du substrat de report.

Selon un mode de réalisation, les deuxièmes plots sont enterrés sous la face de connexion du substrat de report.

Selon l'invention, la face de connexion du substrat de report est plane, les plages de connexion électrique du substrat de report affleurant au niveau d'une face externe d'une couche de passivation du substrat de report.

Selon un exemple comparatif ne faisant pas partie de l'invention, les plages de connexion électrique du substrat de report sont en saillie de la face de connexion du substrat de report.

Selon un mode de réalisation :
à l'issue de l'étape a), les puces sont disposées sur un substrat de support avec un pas inter-puces inférieur au pas inter-puces du dispositif d'affichage final ; et
à l'étape c), plusieurs puces sont sélectivement détachées du substrat de support au pas du dispositif d'affichage final et fixées au substrat de report à ce même pas.

Selon un mode de réalisation :
à l'issue de l'étape a), les puces sont seulement posées, sans collage, sur le substrat de support ; et
à l'étape c) le substrat de report est amené au-dessus des puces, face de connexion tournée vers les faces de connexion des puces, de façon à prélever simultanément plusieurs puces au pas du dispositif d'affichage final.

Selon un mode de réalisation, le substrat de support comprend des cavités dans lesquelles sont disposées les puces de façon que les puces soient maintenues latéralement par les parois des cavités.

Selon un mode de réalisation, le fond de chaque cavité du substrat de support est non plan.

Selon l'invention, chaque puce comprend un empilement d'une LED et d'un circuit actif de commande de la LED.

Un autre mode de réalisation ne faisant pas partie de l'invention telle que revendiquée prévoit un dispositif d'affichage émissif à LED réalisé par un procédé tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant de façon schématique et partielle une étape de report d'une micropuce sur un substrat de report, selon un exemple d'un procédé de fabrication d'un dispositif d'affichage émissif à LED ;
la figure 2 est une vue en coupe illustrant de façon schématique et partielle une étape de report d'une micropuce sur un substrat de report, selon un exemple d'un mode de réalisation d'un procédé de fabrication d'un dispositif d'affichage émissif à LED ;
la figure 3 est une vue en coupe illustrant de façon schématique et partielle une étape de report d'une micropuce sur un substrat de report, selon un autre exemple d'un procédé de fabrication, ne faisant pas partie de l'invention telle que revendiquée, d'un dispositif
   d'affichage émissif à LED ;
la figure 4 est une vue en coupe illustrant de façon schématique et partielle une étape de report d'une micropuce sur un substrat de report, selon un autre exemple d'un mode de réalisation d'un procédé de fabrication d'un dispositif d'affichage émissif à LED ;
les figures 5A, 5B et 5C sont des vues en coupe illustrant des étapes d'un exemple d'un mode de réalisation d'un procédé de fabrication d'un dispositif d'affichage émissif à LED ;
la figure 6 est une vue en coupe illustrant une variante de réalisation du procédé des figures 5A à 5C ;
les figures 7A, 7B, 7C et 7D sont des vues en coupe illustrant des étapes d'un autre exemple d'un mode de réalisation d'un procédé de fabrication d'un dispositif d'affichage émissif à LED ;
les figures 8A, 8B, 8C et 8D sont des vue en coupe illustrant des étapes d'un autre exemple d'un mode de réalisation d'un procédé de fabrication d'un dispositif d'affichage émissif à LED ;
la figure 9 est une vue en coupe illustrant une variante de réalisation du procédé des figures 8A à 8D ; et
les figures 10A, 10B, 10C, 10D et 10E sont des vues en coupe illustrant des étapes d'un exemple d'un procédé de fabrication d'une micropuce d'un dispositif d'affichage émissif à LED selon un mode de réalisation.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la fabrication des micropuces élémentaires et du substrat de report des dispositifs d'affichage décrits n'a pas été détaillée, la fabrication de ces éléments étant à la portée de l'homme du métier à partir des enseignements de la présente description. A titre d'exemple, les micropuces élémentaires et le substrat de report peuvent être fabriqués selon des procédés identiques ou similaires à ceux décrits dans la demande de brevet français n°1561421 susmentionnée, dont le contenu est considéré comme faisant partie intégrante de la présente description et est ici incorporé par référence dans la mesure autorisée par la loi. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près.

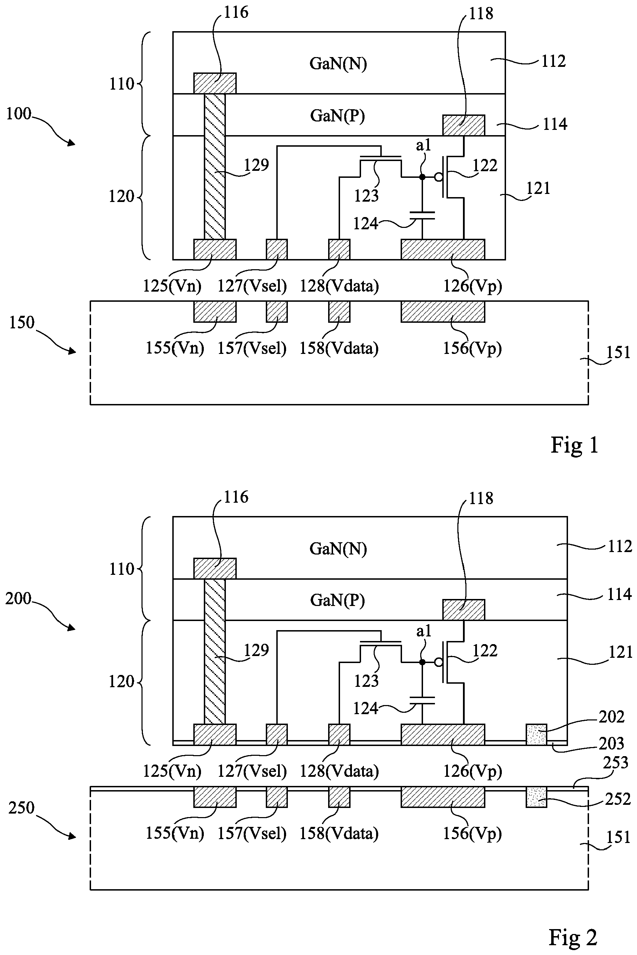

La figure 1 est une vue en coupe illustrant de façon schématique et partielle une étape de report d'une micropuce 100 sur un substrat de report 150, selon un exemple d'un procédé de fabrication d'un dispositif d'affichage émissif à LED.

La figure 1 représente plus particulièrement la micropuce 100 et le substrat de report 150 avant l'étape proprement dite de fixation de la micropuce sur le substrat de report.

En pratique, un dispositif d'affichage comporte une pluralité de puces élémentaires 100 identiques ou similaires montées sur un même substrat de report selon un agencement en matrice selon des lignes et des colonnes, les puces étant connectées à des éléments de connexion électrique du substrat pour leur commande, et chaque micropuce correspondant par exemple à un pixel du dispositif d'affichage.

La micropuce 100 comprend, dans une portion supérieure, une LED semiconductrice inorganique 110, et, dans une portion inférieure solidaire de la portion supérieure, un circuit de commande actif 120 à base de silicium monocristallin, adapté à contrôler l'émission de lumière par la LED.

La LED 110 comprend au moins une homojonction ou une hétérojonction, par exemple une jonction PN formée d'un empilement d'une couche semiconductrice supérieure de type N 112 et d'une couche semiconductrice inférieure de type P 114, et deux contacts électriques 116 et 118 (respectivement en contact avec la couche 112 et avec la couche 114 dans l'exemple représenté) pour injecter un courant électrique au travers de l'empilement, afin de produire de la lumière. A titre d'exemple, la LED 110 est une LED au nitrure de gallium ou à base de tout autre semiconducteur III-V adapté à la réalisation d'une LED.

Le circuit de commande 120 est réalisé dans et sur un bloc de silicium monocristallin 121, et comprend des composants électroniques, et notamment plusieurs transistors et au moins un élément capacitif de maintien d'un signal de polarisation, pour la commande individuelle de la LED 110. La face supérieure du circuit de commande 120 est en contact mécaniquement et électriquement avec la LED 110. La face inférieure du circuit 120, définissant une face de connexion de la micropuce, comprend une pluralité de plages de connexion électrique destinées à être connectées à des plages de connexion électrique correspondantes du substrat de report 150 pour la commande de la micropuce. Dans l'exemple représenté, la face inférieure du circuit 120 comprend quatre plages de connexion électrique 125, 126, 127 et 128. Les plages 125 et 126 sont destinées à recevoir respectivement un potentiel d'alimentation bas (par exemple la masse) Vn et un potentiel d'alimentation haut (c'est-à-dire supérieur au potentiel d'alimentation bas) Vp de la micropuce. Les plages 127 et 128 sont destinées à recevoir des signaux de commande de la micropuce. Plus particulièrement, la plage 127 est destinée à recevoir un signal Vsel de sélection de la micropuce, et la plage 128 est destinée à recevoir un signal Vdata de réglage du niveau de luminosité de la micropuce. Les plages de connexion 125, 126, 127 et 128 sont par exemple en métal, par exemple en cuivre, en or ou en titane. Dans cet exemple, le circuit de commande 120 comprend deux transistors MOS 122 et 123 et un élément capacitif 124, par exemple un condensateur. Le transistor 122, par exemple un transistor à canal P, a un premier noeud de conduction (source ou drain) connecté à la plage de connexion 126 (Vp) de la micropuce, un deuxième noeud de conduction (drain ou source) connecté à la borne de contact d'anode 118 de la LED 110, et un noeud de commande (grille) connecté à un noeud intermédiaire a1 du circuit 120. L'élément capacitif 124 a une première électrode connectée au noeud a1 et une deuxième électrode connectée à la plage de connexion 126 (Vp) de la micropuce. Le transistor 123, par exemple un transistor à canal N a un premier noeud de conduction connecté à la plage de connexion 128 (Vdata) de la micropuce, un deuxième noeud de conduction connecté au noeud a1, et un noeud de commande connecté à la plage de connexion 127 (Vsel) de la micropuce. La micropuce 100 comprend en outre un via conducteur isolé 129 connectant la plage de connexion électrique 125 (Vn) de la micropuce à la borne de contact de cathode 116 de la LED 110.

Le fonctionnement de la micropuce élémentaire 100 lors d'une phase de mise à jour du niveau de luminosité du pixel est le suivant. Le transistor 123 est fermé (rendu passant) par l'application d'un signal de commande adapté sur la borne 127 (Vsel). L'élément capacitif 124 se charge alors à un niveau de tension fonction du signal de réglage appliqué sur la borne 128 (Vdata) de la micropuce. Le niveau du signal de réglage Vdata fixe le potentiel du noeud a1, et par conséquent l'intensité du courant injecté dans la LED par le transistor 122, et donc l'intensité lumineuse émise par la LED. Le transistor 123 peut ensuite être rouvert. Le noeud a1 reste alors à un potentiel sensiblement égal au potentiel Vdata. Ainsi, le courant injecté dans la LED reste sensiblement constant après la réouverture du transistor 123, et ce jusqu'à la prochaine mise à jour du potentiel du noeud a1.

Le substrat de report 150 comprend par exemple une plaque ou une feuille de support 151 en un matériau isolant, sur laquelle sont disposés des éléments de connexion électrique, par exemple des pistes et plages conductrices. Le substrat de report 150 est par exemple un substrat passif, c'est-à-dire qu'il comprend uniquement des éléments de connexion électrique pour l'amenée des signaux de commande et d'alimentation des micropuces. Le substrat de report 150 comprend une face de connexion, sa face supérieure dans l'exemple représenté, destinée à recevoir les micropuces 100. Pour chaque micropuce du dispositif d'affichage, le substrat de report 150 comprend, sur sa face de connexion, une pluralité de plages de connexion électrique (une par plage de connexion électrique de la micropuce) destinées à être connectées respectivement aux plages de connexion électrique de la micropuce. Ainsi, dans cet exemple, pour chaque micropuce 100 du dispositif d'affichage, le substrat de report 150 comprend quatre plages de connexion électrique 155, 156, 157 et 158 destinées à être connectées respectivement aux plages de connexion électrique 125, 126, 127 et 128 de la micropuce 100, pour l'amenée des signaux de commande Vn, Vp, Vsel et Vdata de la micropuce. Les plages de connexion électrique 155, 156, 157 et 158 du substrat de report sont par exemple en le même matériau conducteur que les plages de connexion électrique 125, 126, 127 et 128 des micropuces, par exemple du cuivre, de l'or ou du titane.

Lors du report de la micropuce 100 sur le substrat de report 150, la face de connexion de la micropuce est mise en contact avec la face de connexion du substrat de report de façon à connecter électriquement les plages de connexion électrique 125, 126, 127 et 128 de la micropuce respectivement aux plages de connexion électrique correspondantes 155, 156, 157 et 158 du substrat de report. La fixation de la micropuce 100 sur le substrat de report est réalisée par collage direct, c'est-à-dire sans apport de matière adhésive ou de brasure à l'interface entre la micropuce et le substrat, par exemple à température et à pression ambiante. Pour cela, les plages de connexion électrique de la micropuce et du substrat de report peuvent avoir été préparées au préalable pour obtenir une planéité suffisante, par exemple une rugosité inférieure à 1 nm, pour réaliser un collage direct des plages 125, respectivement 126, respectivement 127, respectivement 128, sur les plages 155, respectivement 156, respectivement 157, respectivement 158. Un recuit peut éventuellement être prévu après le collage, par exemple à une température comprise entre 150 et 250°C, pour augmenter la force du collage.

Comme indiqué ci-dessus, une difficulté d'un tel procédé réside dans l'alignement des plages de connexion électrique de la micropuce sur les plages de connexion électrique correspondantes du substrat de report en vue d'obtenir une bonne connexion électrique entre la micropuce et le substrat de report.

En effet, les micropuces ont par exemple, en vue de dessus, une dimension maximale inférieure ou égale à 100 µm, par exemple inférieure ou égale à 50 µm, par exemple de l'ordre de 10 µm. Chaque micropuce comportant plusieurs plages de connexion électrique (quatre dans l'exemple de la figure 1), l'alignement des micropuces doit être très précis, par exemple précis à mieux que 1 µm.

La figure 2 est une vue en coupe illustrant de façon schématique et partielle une étape de report d'une micropuce 200 sur un substrat de report 250, selon un exemple d'un mode de réalisation d'un procédé de fabrication d'un dispositif d'affichage émissif à LED. La figure 2 représente plus particulièrement la micropuce 200 et le substrat de report 250 avant l'étape proprement dite de fixation de la micropuce sur le substrat de report.

La micropuce 200 et le substrat de report 250 de la figure 2 comprennent des éléments communs avec la micropuce 100 et le substrat de report 150 de la figure 1. Dans la suite, seules les différences entre le mode de réalisation de la figure 2 et l'exemple de la figure 1 seront détaillées.

La micropuce 200 de la figure 2 comprend les mêmes éléments que la micropuce 100 de la figure 1, agencés sensiblement de la même manière, et diffère de la micropuce 100 de la figure 1 principalement en ce qu'elle comprend en outre, au voisinage de sa face de connexion, c'est-à-dire plus proche de sa face de connexion que de sa face opposée, un plot 202 en un matériau ferromagnétique, par exemple un alliage nickel-fer.

Dans l'exemple de la figure 2, le plot 202 débouche du côté de la face de connexion de la micropuce.

De plus, selon l'invention, la face de connexion de la micropuce 200 est sensiblement plane, c'est-à-dire que les plages de connexion électrique 125, 126, 127 et 128 et le plot ferromagnétique 202 de la micropuce affleurent au niveau de la face inférieure d'une couche isolante 203 sensiblement plane de passivation de la micropuce. A titre d'exemple, les plages de connexion électrique 125, 126, 127 et 128 et le plot ferromagnétique 202 de la micropuce sont formés selon un procédé de type damascène, comprenant une étape de dépôt de la couche isolante de passivation 203 sur toute la surface inférieure de la micropuce, suivie d'une étape de gravure de cavités destinées à recevoir les plages de connexion électrique 125, 126, 127 et 128 et le plot 202 du côté de la face inférieure de la micropuce, suivie d'une étape de remplissage des cavités par un matériau conducteur pour former les plages de connexion électrique et par un matériau ferromagnétique pour former le plot 202, suivie d'une étape de polissage mécanochimique pour planariser la surface inférieure de la puce de façon à mettre à un même niveau les faces inférieures des plages de connexion électrique 125, 126, 127 et 128 et du plot 202, et la face inférieure de la couche de passivation 203.

A titre d'exemple, les plages de connexion électrique 125, 126, 127 et 128 de la micropuce 200 sont en le même matériau que le plot ferromagnétique 202, ce qui simplifie le procédé de fabrication des micropuces.

Le substrat de report 250 de la figure 2 comprend les mêmes éléments que le substrat de report 150 de la figure 1, et diffère du substrat de report 150 de la figure 1 principalement en ce qu'il comprend en outre, au voisinage de sa face de connexion, c'est-à-dire plus proche de sa face de connexion que de sa face opposée, pour chaque micropuce 200 du dispositif d'affichage, outre les plages de connexion 155, 156, 157 et 158 destinées à être connectées aux plages de connexion 125, 126, 127 et 128 de la micropuce, un aimant permanent 252 formant un plot ayant, vu de face, sensiblement la même forme générale et les mêmes dimensions que le plot ferromagnétique 202 de la micropuce.

Le positionnement du plot 252 par rapport aux plages de connexion électrique 155, 156, 157 et 158 du substrat de report est sensiblement identique au positionnement du plot 202 par rapport aux plages de connexion électrique 125, 126, 127 et 128 de la micropuce. Autrement dit, lorsque les plages de connexion électrique 125, 126, 127 et 128 de la micropuce sont alignées à la verticale respectivement des plages de connexion électrique 155, 156, 157 et 158 du substrat de report, le plot ferromagnétique 202 de la micropuce se situe à la verticale de l'aimant permanent 252 du substrat de report.

Dans l'exemple de la figure 2, le plot aimant 252 débouche du côté de la face de connexion du substrat de report.

De plus, selon l'invention, la face de connexion du substrat de report est sensiblement plane, c'est-à-dire que les plages de connexion électrique 155, 156, 157 et 158 et le plot aimant 252 du substrat de report affleurent au niveau de la face supérieure d'une couche isolante 253 sensiblement plane de passivation du substrat de report. A titre d'exemple, les plages de connexion électrique 155, 156, 157 et 158 et le plot aimant 252 du substrat de report sont formés selon un procédé de type damascène, comprenant une étape de dépôt de la couche isolante de passivation 253 sur toute la surface supérieure du substrat de report, suivie d'une étape de gravure de cavités destinées à recevoir les plages de connexion électrique 155, 156, 157 et 158 et le plot 252 du côté de la face supérieure du substrat de report, suivie d'une étape de remplissage des cavités par un matériau conducteur pour former les plages de connexion électrique et par un matériau aimant permanent pour former le plot 252, suivie d'une étape de polissage mécanochimique pour planariser la surface supérieure du substrat de façon à mettre à un même niveau les faces supérieures des plages de connexion électrique 155, 156, 157 et 158 et du plot 252, et la face supérieure de la couche de passivation 253.

A titre d'exemple, le plot aimant 252 est constitué d'un empilement de plusieurs couches métalliques, par exemple un empilement d'une couche antiferromagnétique, par exemple en un alliage platine-manganèse, iridium-manganèse ou fer-manganèse, et d'une couche ferromagnétique, par exemple en un alliage fer-cobalt, fer-cobalt-bore ou nickel-fer, en contact avec la couche antiferromagnétique. A titre de variante, le plot aimant peut être constitué par une alternance de plusieurs couches antiferromagnétiques et de plusieurs couches ferromagnétiques alternées. L'empilement peut en outre comprendre une couche inférieure d'amorce, par exemple en tantale, ou en un alliage ruthénium-tantale, et une couche supérieure de protection, par exemple en tantale. Chaque couche du plot aimant présente par exemple une épaisseur comprise entre 5 et 100 nm. Les couches du plot aimant peuvent par exemple être déposées par dépôt physique en phase vapeur (PVD). Après dépôt et gravure aux dimensions souhaitées, un recuit du plot aimant peut être prévu, par exemple à une température comprise entre 150 et 400°C, par exemple sous un champ magnétique compris entre 0,1 et 2 T.

A titre d'exemple le plot aimant est constitué d'un empilement de :
- 25 répétitions successives d'un empilement d'une couche de tantale de 5 nm d'épaisseur, d'une couche d'un alliage Pt50Mn50 de 7 nm d'épaisseur, d'une couche d'un alliage Fe20Co80 de 20 nm d'épaisseur, et d'une couche d'un alliage Pt50Mn50 de 7 nm d'épaisseur ; et
- une couche supérieure de protection en tantale de 10 nm d'épaisseur.

A titre de variante, le plot aimant est constitué d'un empilement de :
- une couche de tantale de 5 nm d'épaisseur ;
- une couche de cuivre de 2 nm d'épaisseur ;
- 30 répétitions successives d'un empilement d'une couche d'un alliage Ir20Mn80 de 7 nm d'épaisseur et d'une couche d'un alliage Fe65Co35 de 25 nm d'épaisseur ;
- une couche d'un alliage Ir20Mn80 de 7 nm d'épaisseur ; et
- une couche de tantale de 10 nm d'épaisseur.

En vue de face, le plot aimant 252 et le plot ferromagnétique 202 ont par exemple chacun une forme générale carrée, rectangulaire ou circulaire, de dimension maximale comprise entre 0,5 et 100 µm. Les plots 202 et 252 présentent de préférence, en vue de face, une dimension maximale du même ordre de grandeur que la précision d'alignement recherchée, par exemple une dimension maximale comprise entre 0,5 et 5 µm, par exemple de l'ordre de 1 à 2 µm.

Lors de l'étape de report proprement dite, la micropuce 200 est amenée en vis-à-vis du substrat de report 250, face de connexion tournée vers la face de connexion du substrat de report. Plus particulièrement, les plages de connexion électrique 125, 126, 127 et 128 de la micropuce sont positionnées approximativement à l'aplomb des plages de connexion électrique correspondantes 155, 156, 157 et 158 du substrat de report, sans toutefois mettre en contact la face de connexion de la micropuce avec la face de connexion du substrat de report. La micropuce est alors relâchée, c'est-à-dire rendue libre de se déplacer, notamment latéralement, par rapport au substrat de report. A ce moment, la force d'aimantation entre le plot ferromagnétique 202 de la micropuce et le plot aimant correspondant 252 du substrat de report conduit à coller la face de connexion de la micropuce contre la face de connexion du substrat de report, en alignant précisément le plot ferromagnétique 202 sur le plot aimant 252, et donc les plages de connexion électrique de la micropuce sur les plages de connexion électrique correspondantes du substrat de report.

On notera que l'auto-alignement de la micropuce sur le substrat de report est réalisé essentiellement avant que la face de connexion de la micropuce n'entre en contact avec la face de connexion du substrat de report. En effet, une fois les faces de connexion de la micropuce et du substrat de report mises en contact, un collage direct est immédiatement obtenu entre les deux faces de connexion, empêchant tout déplacement de la micropuce par rapport au substrat de report. Pour éviter un collage direct trop rapide de la micropuce sur le substrat de report, et ainsi augmenter la durée disponible pour l'auto-alignement de la micropuce sur le substrat de report, un liquide peut éventuellement être disposé à l'interface entre la micropuce et le substrat de report lors du report.

Une fois l'alignement de la micropuce 200 sur le substrat de report réalisé avec l'assistance du plot ferromagnétique 202 et du plot aimant 252, et le collage direct de la micropuce sur le substrat 250 obtenu, un recuit peut éventuellement être prévu, par exemple à une température comprise entre 150 et 250°C, pour augmenter l'énergie de collage et améliorer la connexion électrique entre les plages de connexion 125, 126, 127 et 128 de la micropuce et les plages de connexion 155, 156, 157 et 158 du substrat de report.

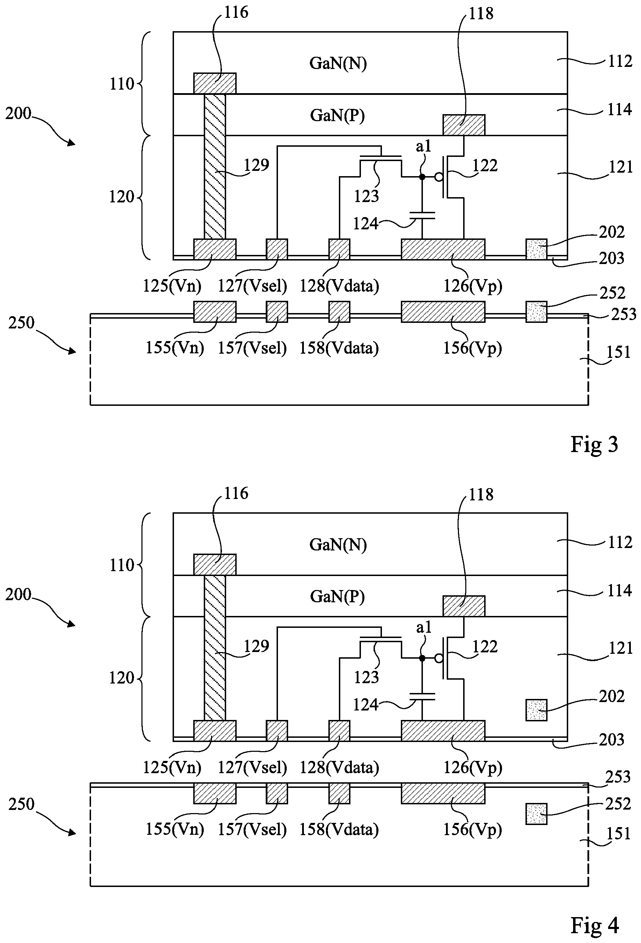

La figure 3 est une vue en coupe illustrant de façon schématique et partielle une variante de réalisation, ne faisant pas partie de l'invention telle que revendiquée, du procédé de report de la figure 2. Comme dans l'exemple de la figure 2, la figure 3 représente la micropuce 200 et le substrat de report 250 avant l'étape proprement dite de fixation de la micropuce sur le substrat de report.

La micropuce de la figure 3 comprend les mêmes éléments que la micropuce de la figure 2, agencés sensiblement de la même manière.

Le substrat de report de la figure 3 comprend les mêmes éléments que le substrat de report de la figure 2, et diffère du substrat de report de la figure 2 principalement en ce que, dans l'exemple de la figure 3, les plages de connexion électrique 155, 156, 157 et 158 et le plot aimant 252 du substrat de report forment des protubérances en saillie de la face de connexion du substrat. Ainsi, à la différence du substrat de report de la figure 2 dont la face de connexion est sensiblement plane, le substrat de report de la figure 3 présente une face de connexion structurée. Plus particulièrement, dans l'exemple représenté, les protubérances formées par les plages de connexion électrique 155, 156, 157 et 158 et le plot aimant 252 ont une forme en mesa ou en plateau.

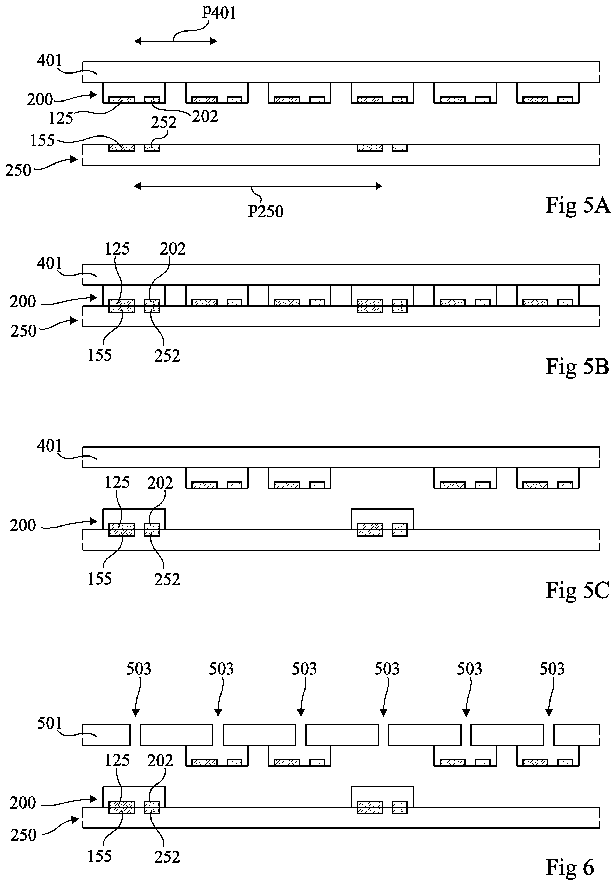

En pratique, comme cela sera expliqué plus en détail ci-après en relation avec les figures 5A à 5C, lors du report des micropuces 200 sur le substrat 250, plusieurs micropuces disposées sur un même substrat de support (non visible sur la figure 3), selon un pas inter-puces inférieur au pas inter-puces du dispositif final, peuvent être amenées en vis-à-vis du substrat de report. Seule une partie des micropuces est alors transférée du substrat de support sur le substrat de report, au pas du substrat de report, les autres micropuces restant sur le substrat de support pour être reportées ultérieurement soit dans une autre région du substrat de report soit sur un autre substrat de report.

Un avantage de la variante de la figure 3 est que la forme en protubérance des plages de connexion électrique 155, 156, 157 et 158 et du plot aimant 252 du substrat de report permet que seules les micropuces transférées du substrat de support sur le substrat de report soient mises en contact avec la face de connexion du substrat de report. Ceci permet notamment d'éviter d'endommager la face de connexion des micropuces destinées à rester sur le substrat de support.

Dans une autre variante ne faisant pas partie de l'invention, seules les plages de connexion électrique 155, 156, 157 et 158 forment des protubérances en saillie de la face de connexion du substrat de report 250, le plot aimant 252 affleurant la face supérieure de la couche de passivation 253 tel que décrit ci-avant en relation avec la figure 2, ou étant enterré sous la face de connexion du substrat de report tel que décrit ci-après en relation avec la figure 4.

La figure 4 est une vue en coupe illustrant de façon schématique et partielle une autre variante de réalisation du procédé de report de la figure 2. Comme dans l'exemple de la figure 2, la figure 4 représente la micropuce 200 et le substrat de report 250 avant l'étape proprement dite de fixation de la micropuce sur le substrat de report.

La micropuce de la figure 4 comprend les mêmes éléments que la micropuce de la figure 2, et diffère de la micropuce de la figure 2 en ce que, dans la micropuce de la figure 4, le plot ferromagnétique 202 n'affleure pas au niveau de la face de connexion de la micropuce, mais est enterré sous la face de connexion de la micropuce.

De façon similaire, le substrat de report de la figure 4 comprend les mêmes éléments que le substrat de report de la figure 2, et diffère du substrat de report de la figure 2 en ce que, dans le substrat de report de la figure 4, le plot aimant 252 n'affleure pas au niveau de la face de connexion du substrat, mais est enterré sous la face de connexion du substrat.

A titre de variante, seul l'un des plots 202 et 252 est enterré, l'autre plot affleurant au niveau de la face externe de la couche de passivation revêtant la face de connexion.

Dans une autre variante le plot ferromagnétique 202 de la micropuce est enterré, et le plot aimant 252 du substrat de report est en saillie de la face de connexion du substrat de report, tel que décrit en relation avec la figure 3.

Les figures 5A, 5B et 5C sont des vues en coupe illustrant des étapes d'un exemple d'un mode de réalisation d'un procédé de fabrication d'un dispositif d'affichage émissif à LED.

La figure 5A illustre une étape au cours de laquelle, après avoir formé séparément les micropuces 200 sur un substrat de support 401, et le substrat de report 250, on vient positionner les micropuces 200 approximativement en vis-à-vis des zones de report correspondantes du substrat 250, faces de connexion des micropuces tournées vers la face de connexion du substrat 250, en se servant du substrat de support 401 comme poignée.

A titre d'exemple, le procédé de fabrication des micropuces 200 est un procédé du type décrit dans la demande de brevet français n°1561421 susmentionnée, comprenant :
la formation d'une matrice de circuits de commande élémentaires 120 identiques ou similaires, dans et sur un substrat de silicium ;
la formation séparée, sur un substrat de croissance adapté, par exemple en saphir, d'une matrice correspondante de LED élémentaires 110 identiques ou similaires ;
le report, l'une sur l'autre, de la matrice de circuits de commande 120 et de la matrice de LED 110, les deux matrices étant solidarisées l'une à l'autre, par exemple par collage direct hétérogène ;
le retrait du substrat de croissance des LED et son remplacement par un substrat de support, correspondant au substrat 401 de la figure 5A, fixé par un collage dit temporaire, présentant une énergie d'adhérence plus faible que la liaison initiale entre les micropuces et le substrat de croissance des LED, de façon à faciliter une étape ultérieure de prélèvement des micropuces ; et
l'individualisation de chaque micropuce 200 en gravant autour d'elle une tranchée s'étendant verticalement de la face de connexion de la micropuce jusqu'au substrat 401, de façon à obtenir une matrice de micropuces individualisées attachées au substrat de support 401 par leurs LED, tel que représenté en figure 5A.

A titre de variante, l'étape de remplacement du substrat de croissance des LED par un substrat de support différent peut être omise, auquel cas le substrat 401 de la figure 5A est le substrat de croissance des LED. Dans ce cas, la liaison entre le substrat 401 et les LED 110 peut éventuellement être affaiblie, au moyen d'un faisceau laser projeté au travers du substrat 401 depuis sa face arrière, c'est-à-dire sa face opposée aux micropuces 200.

Dans une autre variante, l'empilement des couches semiconductrices constitutives des LED peut être rapporté sur la matrice de circuits de commande élémentaires 120 avant individualisation des LED élémentaires 110. Le substrat de croissance des LED est alors retiré pour permettre l'individualisation des LED 110, puis le substrat de support 401 peut être collé à la face des LED 110 opposée aux circuits de commande 120.

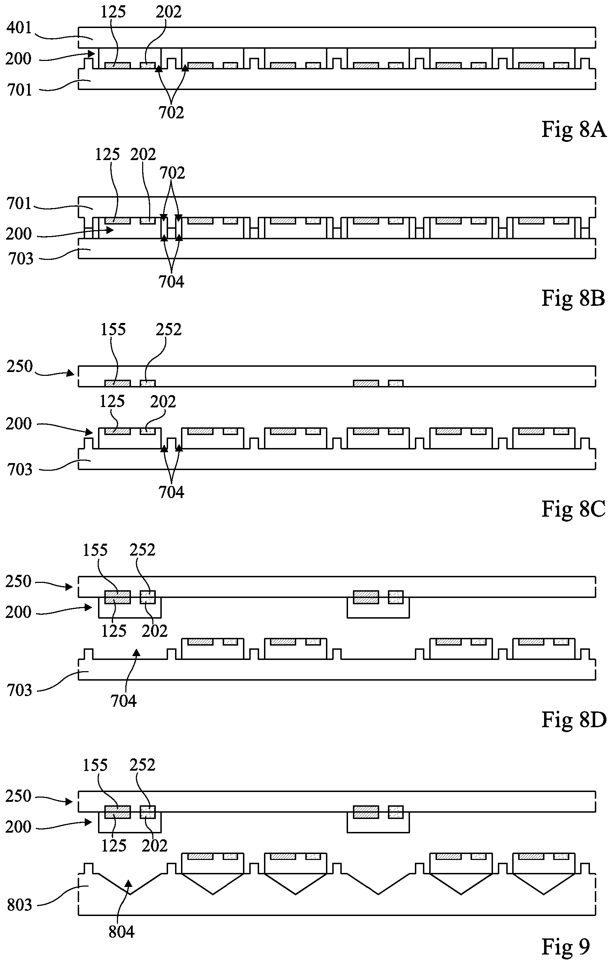

Par souci de simplification, on a représenté sur les figures 5A à 5C, ainsi que sur les figures suivantes (jusqu'à la figure 9), une seule plage de connexion électrique 125 par micropuce. En pratique, comme indiqué précédemment, chaque micropuce comprend plusieurs plages de connexion électrique sur sa face de connexion. De plus, toujours par souci de simplification des figures, les micropuces 200 n'ont pas été détaillées sur les figures 5A à 5C et suivantes. Seul le plot ferromagnétique 202 est visible en plus de la plage de connexion électrique 125.

De façon similaire, le substrat de report 250 n'a pas été détaillé sur les figures 5A à 5C et suivantes. Pour chaque zone de réception d'une micropuce, seuls le plot aimant 252 et une plage de connexion électrique 155 unique sont représentés.

Les micropuces 200 attachées au substrat de support 401 par leurs LED sont amenées en vis-à-vis de zones de réception correspondantes du substrat de report 250, faces de connexion tournées vers la face de connexion du substrat 250.

Le substrat de support 401 est alors relâché, c'est-à-dire laissé libre de se déplacer, notamment latéralement, par rapport au substrat de report 250.

A ce stade, la force d'aimantation exercée entre le plot ferromagnétique 202 de chaque micropuce et le plot aimant 252 correspondant du substrat de report permet d'aligner précisément les plages de connexion électrique de chaque micropuce sur les plages de connexion électrique correspondantes du substrat de report.

On notera que le fait de rapporter simultanément plusieurs micropuces 200 sur le substrat 250 permet de bénéficier d'une force de rappel d'alignement plus élevée que si une puce unique était rapportée, dans la mesure où les forces d'aimantation exercées par les couples plot ferromagnétique/plot aimant associés aux différentes micropuces reportées s'additionnent.

Les micropuces 200 sont ensuite fixées sur le substrat de report 250 par collage direct des plages de connexion électrique des micropuces sur les plages de connexion électrique correspondantes du substrat de report.

Les micropuces 200 sont ensuite détachées du substrat de support 401, et ce dernier est retiré.

En pratique, le pas p₄₀₁ des micropuces sur le substrat 401, par exemple de l'ordre de 10 à 50 µm, peut être inférieur au pas p₂₅₀ du dispositif final après report sur le substrat 250, par exemple compris entre 15 µm et 1 mm, par exemple de l'ordre de 100 à 500 µm.

Dans l'exemple décrit en relation avec les figures 5A à 5C, ainsi que dans les exemples des figures suivantes, le pas p₂₅₀ des micropuces 200 sur le substrat de report 250 est un multiple du pas p₄₀₁ des micropuces sur le substrat de support 401. Ainsi, on prévoit de reporter seulement une partie des micropuces 200 du substrat 401 sur le substrat 250, au pas du substrat de report 250 (soit une puce sur n avec n = p₂₅₀/p₄₀₁), puis, si besoin, de décaler le substrat 401 avec les micropuces restantes pour reporter une autre partie des micropuces 200 du substrat 401 sur le substrat 250, et ainsi de suite jusqu'à ce que toutes les micropuces du dispositif d'affichage aient été fixées sur le substrat de report 250.

A chaque itération, une fois l'alignement des micropuces 200 sur le substrat de report réalisé avec l'assistance des couples plot ferromagnétique 202/plot aimant 252 (figure 5B), les micropuces 200 sont détachées sélectivement du substrat de support 401. Le substrat de support 401 et les micropuces 200 restantes sont ensuite être retirés comme illustré par la figure 5C.

Pour détacher sélectivement les micropuces 200 du substrat de support 401, on peut prévoir un collage faible entre le substrat de support 401 et les micropuces 200, de façon que seules les micropuces 200 alignées avec des plages de connexion correspondantes du substrat de report 250 soient arrachées lors du retrait du substrat de support 401, sous l'effet de la force d'aimantation exercée entre le plot ferromagnatique 202 et le plot aimant 252, ou sous l'effet de la force de collage direct entre la micropuce et le substrat de report. A titre d'exemple, les micropuces 200 sont collées au substrat de support 401 à l'aide d'un polymère de type C4F8, TEFLON, ou OPTOOL DSX, ou par tout autre adhésif permettant d'obtenir une énergie de collage entre les micropuces 200 et le substrat de support 401 inférieure à l'énergie d'adhérence entre les micropuces 200 et le substrat de report 250.

A titre de variante, dans le cas où le substrat de support 401 est transparent, le collage des micropuces 200 au substrat de support 401 peut être réalisé par une résine adaptée à être dégradée par un rayonnement ultraviolet, par exemple une résine de type BREWER 305. Une insolation laser localisée de la résine peut alors être réalisée au travers du substrat 401, pour détacher sélectivement une partie des micropuces 200.

Dans le cas où le substrat de support 401 est le substrat de croissance des LED 110, ce dernier peut présenter une adhérence relativement forte avec les micropuces 200. Dans ce cas, on peut utiliser un procédé de décollement sélectif au moyen d'un faisceau laser localisé projeté à travers le substrat 401, par exemple un procédé du type décrit dans la demande de brevet US6071795. Par exemple, dans le cas d'un substrat de croissance 401 en saphir et de LED au nitrure de gallium, un laser à 458 nm peut être utilisé, avec une puissance optique comprise entre 10 mW/mm² et 10 W/mm², et un temps d'exposition compris entre 1 seconde et 1 minute pour chaque puce à décoller. Après l'exposition au laser, du gallium liquide est présent à l'interface entre la LED et le saphir. La micropuce tient alors par capillarité sur le substrat 401, jusqu'à son report sur le substrat 250.

On notera que pour augmenter la force de collage entre les micropuces 200 et le substrat de report 250, et ainsi faciliter le décollement du substrat de support 401, on peut effectuer, avant le retrait du substrat 401 (figure 5C), un recuit visant à augmenter l'énergie de collage entre les micropuces et le substrat de report, par exemple à une température comprise entre 150 et 250°C.

La figure 6 est une vue en coupe illustrant une variante de réalisation du procédé des figures 5A à 5C.

Le procédé de la figure 6 diffère du procédé des figures 5A à 5C principalement en ce que, dans le procédé de la figure 6, le substrat de support 401 des figures 5A à 5C est remplacé par un substrat de support 501, comprenant au moins une ouverture traversante 503 en regard de chaque micropuce 200. La prévision des ouvertures traversantes 503 permet de faciliter le détachement sélectif des micropuces 200 lors de leur report sur le substrat 250. A titre d'exemple, les micropuces 200 sont maintenues collées au substrat 501 par un adhésif, et un flux d'air comprimé est injecté de façon localisée dans les ouvertures 503 situées en regard des micropuces à détacher, pour obtenir leur décollement. A titre de variante, des microaiguilles peuvent être utilisées pour pousser de façon sélective les micropuces à détacher à travers les ouvertures 503 correspondantes. A titre de variante, les micropuces sont maintenues collées au substrat 501 par aspiration à travers les ouvertures 503, puis l'aspiration est interrompue de façon localisée en regard des micropuces à détacher, pour obtenir leur décollement.

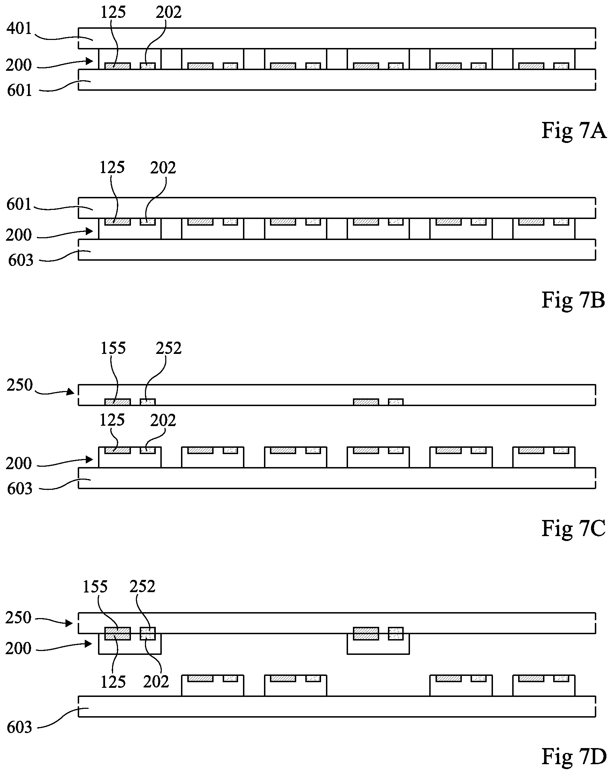

Les figures 7A à 7D sont des vues en coupe illustrant des étapes d'un autre exemple d'un mode de réalisation d'un procédé de fabrication d'un dispositif d'affichage émissif à LED.

La figure 7A illustre une étape au cours de laquelle, après avoir formé les micropuces 200 sur un premier substrat de support 401 de façon identique ou similaire à ce qui a été décrit précédemment en relation avec la figure 5A, les micropuces 200 sont transférées du substrat 401 sur un deuxième substrat de support 601, sans changement de pas. Pour cela, les micropuces 200 sont disposées sur le substrat 601 en se servant du substrat 401 comme poignée. Les micropuces 200 sont mises en contact, par leurs faces de connexion, c'est-à-dire leurs faces opposées aux LED 110, avec une face du substrat 601. Un collage temporaire à l'aide d'une couche adhésive peut être prévu entre la face de connexion des micropuces et le substrat 601. A titre de variante, les micropuces 601 sont simplement posées sur la face supérieure du substrat 601. Le substrat de support initial 401 est ensuite retiré.

La figure 7B illustre une étape postérieure au retrait du substrat de support initial 401, au cours de laquelle les micropuces 200 sont transférées du deuxième substrat de support 601 sur la face supérieure d'un troisième substrat de support 603, toujours en conservant le pas initial. Dans le cas où les micropuces 200 sont collées au substrat de support temporaire 601 par une couche adhésive, les micropuces peuvent être reportées sur la face supérieure du substrat 603 en se servant du substrat 601 comme poignée. Dans le cas où les micropuces 200 sont simplement posées sur la face supérieure du substrat de support temporaire 601, le substrat 603 peut être posé sur la face supérieure des micropuces 200, c'est-à-dire côté LED 110, puis l'ensemble comprenant le substrat 601, les micropuces 200 et le substrat 603 est retourné de façon que les micropuces 200 se retrouvent côté face supérieure du substrat 603. Le substrat de support temporaire 601 est ensuite retiré.

La figure 7C illustre une étape postérieure au retrait du substrat 601. A ce stade, les micropuces 200 sont simplement posées (et non collées) sur la face supérieure du substrat de support 603, les faces de connexion des micropuces étant tournées vers le haut, c'est-à-dire à l'opposé du substrat 603.

Le substrat de report 250 sur lequel on souhaite fixer des micropuces 200, est alors positionné au-dessus du substrat 603 et des micropuces 200, face de connexion tournée vers les faces de connexion des micropuces. Les micropuces 200, posées sur le substrat de support 603, sont amenées en vis-à-vis des zones de réception correspondantes du substrat de report 250.

La force d'aimantation exercée par les plots aimants 252 du substrat de report sur les plots ferromagnétiques 202 des micropuces attire les micropuces 200 (qui sont libres de bouger par rapport au substrat 603 du fait de l'absence de collage entre les micropuces et le substrat 603), et conduit à auto-aligner précisément les plages de connexion de chaque micropuce sur les plages de connexion électrique correspondantes du substrat de report. Les micropuces 200 sont alors fixées sur le substrat de report 250 par collage direct.

Le substrat de support 603 et les micropuces 200 restantes peuvent ensuite être retirés comme illustré par la figure 7D.

Les figures 8A à 8D sont des vues en coupe illustrant des étapes d'un autre exemple d'un mode de réalisation d'un procédé de fabrication d'un dispositif d'affichage émissif à LED.

Le procédé des figures 8A à 8D est similaire au procédé des figures 7A à 7D, et diffère du procédé des figures 7A à 7D principalement en ce que, dans le procédé des figures 8A à 8D, les substrats de support 601 et 603 du procédé des figures 7A à 7D sont remplacés par des substrats 701 et 703 respectivement. Les substrats 701 et 703 diffèrent des substrats 601 et 603 en ce qu'ils comportent chacun, du côté de leur face destinée à recevoir les micropuces 200, des cavités 702 (pour le substrat 701), respectivement 704 (pour le substrat 703), destinées à recevoir les micropuces 200.

Plus particulièrement, lors du transfert des micropuces 200 du substrat de support initial 401 sur le substrat 701 (figure 8A), chaque micropuce 200 est disposée dans une cavité 702 du substrat 701, et est séparée des autres micropuces 200 reportées sur le substrat 701 par les parois latérales de la cavité 702. Autrement dit, le pas des cavités 702 du substrat 701 est sensiblement identique au pas des micropuces 200 sur le substrat 401. De façon similaire à ce qui a été décrit en relation avec les figures 7A à 7D, les micropuces 200 peuvent être fixées au substrat de support temporaire 701 par une couche adhésive, ou peuvent être simplement posées sur le substrat 701. Le substrat de support initial 401 est ensuite retiré.

Par ailleurs, lors du transfert des micropuces 200 du substrat de support temporaire 701 sur le substrat de support 703 (figure 8B), chaque micropuce 200 est disposée dans une cavité 704 du substrat 703, et est séparée des autres micropuces 200 par les parois latérales de la cavité 704. Autrement dit, le pas des cavités 704 du substrat 703 est sensiblement identique au pas des micropuces 200 sur le substrat initial 401. De façon similaire à ce qui a été décrit en relation avec les figures 7A à 7D, les micropuces 200 sont simplement posées sur le substrat de support 703.

Les autres étapes du procédé sont identiques ou similaires à ce qui a été décrit précédemment en relation avec les figures 7A à 7D.

Un avantage de la variante des figures 8A à 8D est de faciliter la manipulation des substrats de support 701 et/ou 703 une fois ces derniers chargés en micropuces 200, grâce au maintien latéral des micropuces obtenu par la prévision des cavités 702, 704.

La figure 9 est une vue en coupe illustrant une variante de réalisation du procédé des figures 8A à 8D.

La figure 9 illustre plus particulièrement une étape finale du procédé, correspondant à l'étape de la figure 8D.

Dans la variante de la figure 9, le substrat de support 703 du procédé des figures 8A à 8D est remplacé par un substrat de support 803. Le substrat 803 comprend des cavités 804 de maintien des micropuces 200, disposées selon un pas sensiblement égal au pas des micropuces sur le substrat de support initial 401. Le substrat 803 du procédé de la figure 9 diffère du substrat 703 du procédé des figures 8A à 8D principalement en ce que le fond de chaque cavité 804 du substrat 803 est non plan. Autrement dit, à la différence du substrat 703 dans lequel toute la surface d'une micropuce 200 opposée à la face de connexion de la micropuce est en contact avec le fond d'une cavité 704 du substrat, dans l'exemple de la figure 9, pour chaque micropuce 200, seule une partie de la surface de la micropuce opposée à sa face de connexion est en contact avec le fond de la cavité 804 dans laquelle est disposée la micropuce. Ceci permet d'empêcher une adhérence non souhaitée des micropuces 200 au fond des cavités du substrat 803, et ainsi de faciliter le prélèvement des micropuces par le substrat de report 250 lors de l'étape d'auto-assemblage.

A titre d'exemple, le fond de chaque cavité 804 du substrat 803 peut avoir une forme en creux, par exemple la forme d'une portion de rainure à section triangulaire. Plus généralement, toute autre forme non plane adaptée à obtenir l'effet anti-adhérent recherché peut être utilisée, par exemple une forme bombée.

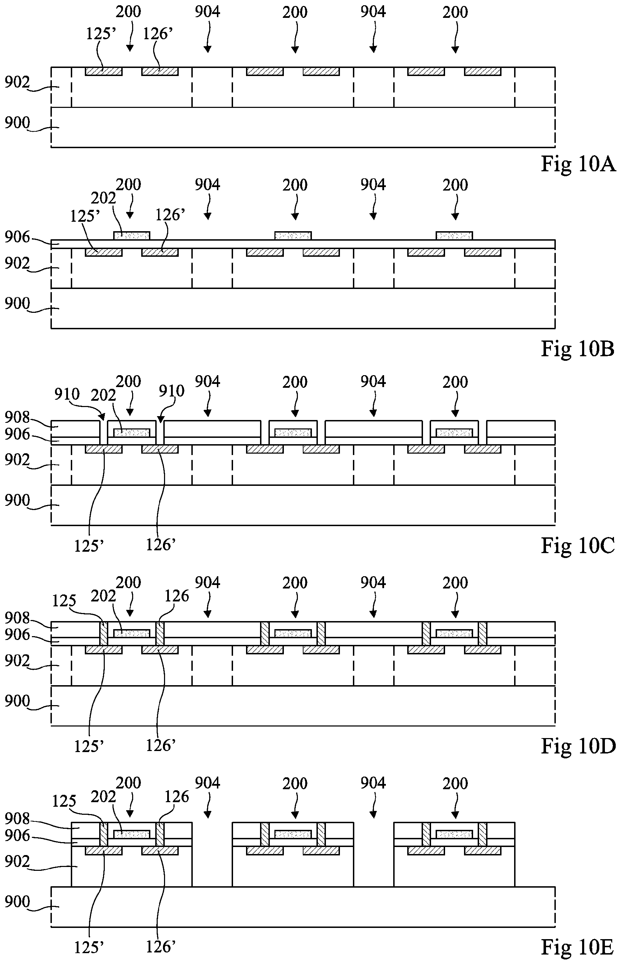

Les figures 10A à 10E sont des vues en coupe illustrant des étapes d'un exemple d'un mode de réalisation de micropuces 200 du type décrit en relation avec la figure 4, c'est-à-dire comportant chacune une face de connexion plane avec des plages de connexion électrique affleurant la face de connexion de la micropuce, et un plot ferromagnétique enterré sous la face de connexion de la micropuce.

Dans l'exemple des figures 10A à 10E, seules deux plages de connexion électrique 125 et 126 sont représentées sur chaque micropuce 200. En pratique, le nombre de plages de connexion électrique par micropuce peut être supérieur à deux.

La figure 10A illustre une étape lors de laquelle on part d'un assemblage comportant un substrat de support 900, et, sur la face supérieure du substrat de support 900, un empilement 902 de couches semiconductrices, conductrices et isolantes, dans lequel sont formés les différents composants des micropuces, et notamment les LED 110 et les circuits de commande 120 (non détaillés sur les figures 10A à 10E). A titre d'exemple, le substrat 900 est le substrat de croissance des LED, et chaque micropuce comprend une LED 110 dans une portion inférieure en contact avec la face supérieure du substrat 900, et un circuit de commande 120 dans une portion supérieure en contact avec la face supérieure de la LED 110.

A l'étape de la figure 10A, les micropuces 200 n'ont pas encore été individualisées. Des traits interrompus représentent les bords latéraux de chaque micropuce 200. Des chemins de découpe 904 séparent les micropuces 200 les unes des autres.

A cette étape, la face supérieure de l'empilement 902 comprend, pour chaque micropuce 200, deux plages de connexion électrique 125' et 126', destinées à être connectées respectivement aux plages de connexion à l'extérieur 125 et 126 de la micropuce, non encore formées.

La figure 10B illustre une étape de dépôt d'une couche isolante 906, par exemple une couche d'oxyde, sur toute la surface supérieure de la structure de la figure 10A.

La figure 10B illustre en outre une étape de formation des plots ferromagnétiques 202 sur la face supérieure de la couche isolante 906. A titre d'exemple, le matériau ferromagnétique est d'abord déposé sur toute la surface supérieure de la couche 906, puis gravé de façon à ne conserver qu'un plot 202 par micropuce 200.

La figure 10C illustre une étape de dépôt d'une couche isolante 908, par exemple une couche d'oxyde, sur toute la surface supérieure de la structure de la figure 10B, c'est-à-dire sur la surface supérieure de la couche 906 et sur la surface supérieure des plots ferromagnétiques 202. L'épaisseur de la couche isolante 908 est de préférence supérieure à l'épaisseur des plots ferromagnétiques 202.

La figure 10C illustre en outre une étape de formation d'ouvertures 910 traversant les couches isolantes 908 et 906 en regard des plages de connexion électrique 125' et 126' de chaque micropuce 200. Les ouvertures 910 sont formées par gravure à partir de la face supérieure de la couche 908, et débouchent sur la face supérieure des plages de connexion électrique 125', respectivement 126'.

La figure 10D illustre une étape de remplissage des ouvertures 910 par un matériau conducteur, par exemple du métal, pour former les plages de connexion électrique 125 et 126 des micropuces 200. A titre d'exemple, le matériau conducteur est déposé sur toute la surface supérieure de la structure de la figure 10C, sur une épaisseur au moins égale à celle des ouvertures 910 de façon à remplir les ouvertures 910. Une étape de polissage mécanochimique est ensuite mise en oeuvre pour planariser la surface supérieure de la structure de façon à mettre à un même niveau les plages de connexion électrique 125 et 126 et la couche isolante supérieure 908.

La figure 10E illustre une étape d'individualisation des micropuces postérieure à la formation des plages de connexion électrique 125 et 126. Lors de cette étape, l'empilement comprenant les couches isolantes 908 et 906 et l'empilement 902 est retiré, dans les chemins de découpe 904, depuis la face supérieure de la couche 908 jusqu'à la face supérieure du substrat de support 900. On obtient ainsi une pluralité de micropuces 200 solidaires du substrat 900, chaque micropuce étant reliée au substrat 900 par sa face opposée à sa face de connexion.

Des modes de réalisation particuliers ont été décrits. Diverses variantes et modifications apparaîtront à l'homme de l'art, dans les limites décrites par la revendication 1.

En particulier, les modes de réalisation décrits ne se limitent pas aux exemples particuliers de dimensions et de matériaux mentionnés dans la description.

En outre, bien que l'on ait décrit uniquement des exemples de réalisation dans lesquels chaque micropuce comprend un plot ferromagnétique et chaque zone de réception correspondante du substrat de report comprend un plot aimant, on pourra, à titre de variante, disposer les plots aimants dans les micropuces et les plots ferromagnétiques dans le substrat de report.

A titre de variante, les plots ferromagnétiques sont remplacés par des plots aimants, c'est-à-dire que chaque micropuce comprend un plot aimant et chaque zone de réception correspondante comprend également un plot aimant.

On notera de plus que les plots de la micropuce et les plots correspondants du substrat de report peuvent avoir des dimensions et/ou des formes différentes.

En outre, pour augmenter encore la précision d'alignement, on pourra prévoir plusieurs plots ferromagnétiques ou plusieurs plots aimants par micropuce, et plusieurs plots aimants correspondants ou plusieurs plots ferromagnétiques correspondants par zone de réception du substrat de report, les dimensions et/ou formes des différents plots pouvant être différentes.

A titre de variante, chaque micropuce peut comporter une pluralité de LED et un circuit de commande de la pluralité de LED.

On notera par ailleurs que, dans des exemples comparatifs ne faisant pas partie de l'invention telle que revendiquée, les procédés décrits peuvent être appliqués d'autres domaines qu'à la réalisation de dispositifs d'affichage émissif à LED. Plus généralement, dans des exemples comparatifs ne faisant pas partie de l'invention telle que revendiquée, les procédés décrits s'appliquent à la réalisation de tout dispositif électronique comportant une pluralité de micropuces reportées sur un substrat de report, dans lequel les micropuces sont fixées et connectées électriquement au substrat de report par collage direct, et dans lequel chaque micropuce comprend au moins deux plages de connexion électrique sur sa face de connexion au substrat de report.

## Revendications

1. Procédé de fabrication d'un dispositif d'affichage électronique, comprenant les étapes suivantes :
a) réaliser une pluralité de puces (200) comprenant chacune :
- une pluralité de plages de connexion électrique (125, 126, 127, 128) disposées sur une face de connexion de la puce, et
- au moins un premier plot (202) disposé au voisinage de la face de connexion de la puce ;
b) réaliser un substrat de report (250) comprenant, pour chaque puce :
- une pluralité de plages de connexion électrique (155, 156, 157, 158) disposées sur une face de connexion du substrat de report, et
- au moins un deuxième plot (252) disposé au voisinage de la face de connexion du substrat de report, l'un des premier et deuxième plots étant un aimant permanent et l'autre des premier et deuxième plots étant soit un aimant permanent soit en un matériau ferromagnétique ; et
c) fixer les puces (200) sur le substrat de report (250) par collage direct de façon à connecter électriquement les plages de connexion électrique (125, 126, 127, 128) de chaque puce aux plages de connexion électrique correspondantes (155, 156, 157, 158) du substrat de report, en utilisant la force d'aimantation entre les premiers (202) et deuxièmes (252) plots pour aligner les plages de connexion électrique des puces sur les plages de connexion électrique correspondantes du substrat de report,
dans lequel, dans chaque puce, la face de connexion de la puce est plane, les plages de connexion électrique (125, 126, 127 et 128) de la puce affleurant au niveau d'une face externe d'une couche de passivation (203) de la puce,
et dans lequel la face de connexion du substrat de report (250) est plane, les plages de connexion électrique (155, 156, 157, 158) du substrat de report affleurant au niveau d'une face externe d'une couche de passivation (253) du substrat de report,
**caractérisé en ce que** chaque puce (200) comprend un empilement d'une LED (110) et d'un circuit actif (120) de commande de la LED, le circuit actif (120) comprenant plusieurs transistors et au moins un élément capacitif (124) de maintien d'un signal de polarisation pour la commande individuelle de la LED (110).

2. Procédé selon la revendication 1, dans lequel, dans chaque puce (200), le premier plot (202) débouche du côté de la face de connexion de la micropuce.

3. Procédé selon la revendication 1, dans lequel, dans chaque puce (200), le premier plot (202) est enterré sous la face de connexion de la puce.

4. Procédé selon l'une quelconque des revendications 1 à 3, dans lequel les deuxièmes plots (252) débouchent du côté de la face de connexion du substrat de report (250).

5. Procédé selon l'une quelconque des revendications 1 à 3, dans lequel les deuxièmes plots (252) sont enterrés sous la face de connexion du substrat de report (250).

6. Procédé selon l'une quelconque des revendications 1 à 5, dans lequel :
à l'issue de l'étape a), les puces (200) sont disposées sur un substrat de support (401 ; 501 ; 603 ; 703 ; 803) avec un pas inter-puces inférieur au pas inter-puces du dispositif d'affichage final ; et
à l'étape c), plusieurs puces (200) sont sélectivement détachées du substrat de support (401 ; 501 ; 603 ; 703 ; 803) au pas du dispositif d'affichage final et fixées au substrat de report à ce même pas.

7. Procédé selon la revendication 6, dans lequel :
à l'issue de l'étape a), les puces (200) sont seulement posées, sans collage, sur le substrat de support (603 ; 703 ; 803) ; et
à l'étape c) le substrat de report (250) est amené au-dessus des puces (200), face de connexion tournée vers les faces de connexion des puces, de façon à prélever simultanément plusieurs puces au pas du dispositif d'affichage final.

8. Procédé selon la revendication 7, dans lequel le substrat de support (703 ; 803) comprend des cavités (704 ; 804) dans lesquelles sont disposées les puces (200) de façon que les puces soient maintenues latéralement par les parois des cavités.

9. Procédé selon la revendication 8, dans lequel le fond de chaque cavité (804) du substrat de support (803) est non plan.

10. Procédé selon l'une quelconque des revendications 1 à 9, dans lequel, à l'étape c), ledit collage direct est réalisé à température et à pression ambiante.

## Patentansprüche

1. Ein Verfahren zur Herstellung einer elektronischen Anzeigevorrichtung, das die folgenden Schritte aufweist:
a) Ausbilden einer Vielzahl von Chips (200), die jeweils Folgendes aufweisen:
- eine Vielzahl von elektrischen Verbindungsbereichen (125, 126, 127, 128), die auf einer Verbindungsfläche des Chips angeordnet sind, und
- mindestens ein erstes Pad bzw. ein erster Bereich (202), das/der in der Nähe der Verbindungsfläche des Chips angeordnet ist;
b) Ausbilden eines Transfersubstrats (250), das für jeden Chip Folgendes aufweist:
- eine Vielzahl von elektrischen Verbindungsbereichen (155, 156, 157, 158), die auf einer Verbindungsfläche des Transfersubstrats angeordnet sind, und
- mindestens ein zweites Pad bzw. ein zweiter Bereich (252), das/der in der Nähe der Verbindungsfläche des Transfersubstrats angeordnet ist, wobei eines der ersten und zweiten Pads ein Permanentmagnet ist und das andere der ersten und zweiten Pads entweder ein Permanentmagnet ist oder aus einem ferromagnetischen Material besteht; und
c) Befestigen der Chips (200) an dem Transfersubstrat (250) durch direktes Bonden, um die elektrischen Verbindungsbereiche (125, 126, 127, 128) jedes Chips mit den entsprechenden elektrischen Verbindungsbereichen (155, 156, 157, 158) des Transfersubstrats elektrisch zu verbinden, und zwar unter Verwendung der Magnetkraft zwischen der ersten (202) und der zweiten (252) Kontaktfläche, um die elektrischen Verbindungsbereiche des Chips mit den entsprechenden elektrischen Verbindungsbereichen des Transfersubstrats auszurichten,
wobei in jedem Chip die Verbindungsfläche des Chips planar ist, wobei die elektrischen Verbindungsbereiche (125, 126, 127 und 128) des Chips bündig mit einer äußeren Oberfläche einer Passivierungsschicht (203) des Chips sind,
und wobei die Verbindungsfläche des Transfersubstrats (250) planar ist, wobei die elektrischen Verbindungsbereiche (155, 156, 157, 158) des Transfersubstrats bündig mit einer äußeren Oberfläche einer Passivierungsschicht (253) des Transfersubstrats sind,
**dadurch gekennzeichnet, dass** jeder Chip (200) einen Stapel aus einer LED (110) und einer aktiven Schaltung (120) zur Steuerung der LED aufweist, wobei die aktive Schaltung (120) eine Vielzahl von Transistoren und mindestens ein kapazitives Element (124) zum Halten eines Vorspannungssignals für die individuelle Steuerung der LED (110) aufweist.

2. Verfahren nach Anspruch 1, wobei in jedem Chip (200) das erste Pad (202) auf der Seite der Verbindungsfläche des Mikrochips freiliegt.

3. Verfahren nach Anspruch 1, bei dem in jedem Chip (200) das erste Pad (202) unter der Verbindungsfläche des Chips vergraben ist.

4. Verfahren nach einem der Ansprüche 1 bis 3, wobei die zweiten Pads (252) auf der Seite der Verbindungsfläche des Transfersubstrats (250) freiliegen.

5. Verfahren nach einem der Ansprüche 1 bis 3, bei dem die zweiten Pads (252) unter der Verbindungsfläche des Transfersubstrats (250) vergraben sind.

6. Verfahren nach einem der Ansprüche 1 bis 5, wobei:
am Ende von Schritt a) die Chips (200) auf einem Trägersubstrat (401; 501; 603; 703; 803) mit einem Abstand zwischen den Chips angeordnet werden, der kleiner ist als der Abstand zwischen den Chips der endgültigen Anzeigevorrichtung; und
in Schritt c) eine Vielzahl von Chips (200) selektiv von dem Trägersubstrat (401; 501; 603; 703; 803) mit dem Abstand der endgültigen Anzeigevorrichtung getrennt und auf dem Transfersubstrat mit demselben Abstand befestigt werden.

7. Verfahren nach Anspruch 6, wobei:
am Ende von Schritt a) die Chips (200) nur auf das Trägersubstrat (603; 703; 803) gelegt werden, ohne dass sie verbunden werden; und
in Schritt c) das Transfersubstrat (250) über die Chips (200) gebracht wird, wobei seine Verbindungsfläche den Verbindungsflächen der Chips zugewandt ist, um gleichzeitig eine Vielzahl von Chips im Abstand der endgültigen Anzeigevorrichtung aufzunehmen.

8. Verfahren nach Anspruch 7, wobei das Trägersubstrat (703; 803) Hohlräume (704; 804) aufweist, in denen die Chips (200) so angeordnet sind, dass die Chips seitlich von den Hohlraumwänden gehalten werden.

9. Verfahren nach Anspruch 8, wobei der Boden jedes Hohlraums (804) des Trägersubstrats (803) nicht eben ist.

10. Verfahren nach einem der Ansprüche 1 bis 9, wobei in Schritt c) das direkte Bonden bei Umgebungstemperatur und -druck durchgeführt wird.

## Claims

1. A method of manufacturing an electronic display device, comprising the steps of:
a) forming a plurality of chips (200), each comprising:
- a plurality of electric connection areas (125, 126, 127, 128) arranged on a connection surface of the chip, and
- at least one first pad (202) arranged in the vicinity of the chip connection surface;
b) forming a transfer substrate (250) comprising, for each chip:
- a plurality of electric connection areas (155, 156, 157, 158) arranged on a connection surface of the transfer substrate, and
- at least one second pad (252) arranged in the vicinity of the connection surface of the transfer substrate, one of the first and second pads being a permanent magnet and the other of the first and second pads being either a permanent magnet or made of a ferromagnetic material; and
c) affixing the chips (200) to the transfer substrate (250) by direct bonding to electrically connect the electric connection areas (125, 126, 127, 128) of each chip to the corresponding electric connection areas (155, 156, 157, 158) of the transfer substrate, by using the magnetic force between the first (202) and second (252) pads to align the electric connection areas of the chips with the corresponding electric connection areas of the transfer substrate,
wherein, in each chip, the connection surface of the chip is planar, the electric connection areas (125, 126, 127, and 128) of the chip being flush with an external surface of a passivation layer (203) of the chip,
and wherein the connection surface of the transfer substrate (250) is planar, the electric connection areas (155, 156, 157, 158) of the transfer substrate being flush with an external surface of a passivation layer (253) of the transfer substrate,
**characterized in that** each chip (200) comprises a stack of a LED (110) and of an active circuit (120) for controlling the LED, the active circuit (120) comprising a plurality of transistors and at least one capacitive element (124) for holding a bias signal, for the individual control of LED (110).

2. The method of claim 1, wherein, in each chip (200), the first pad (202) emerges on the side of the connection surface of the microchip.

3. The method of claim 1, wherein, in each chip (200) the first pad (202) is buried under the connection surface of the chip.

4. The method of any of claims 1 to 3, wherein the second pads (252) emerge on the side of the connection surface of the transfer substrate (250).

5. The method of any of claims 1 to 3, wherein the second pads (252) are buried under the connection surface of the transfer substrate (250).

6. The method of any of claims 1 to 5, wherein:
at the end of step a), the chips (200) are arranged on a support substrate (401; 501; 603; 703; 803) with a pitch between chips smaller than the pitch between chips of the final display device; and
at step c), a plurality of chips (200) are selectively separated from the support substrate (401; 501; 603; 703; 803) at the pitch of the final display device and affixed to the transfer substrate at this same pitch.

7. The method of claim 6, wherein:
at the end of step a), the chips (200) are only laid, with no bonding, on the support substrate (603; 703; 803); and
at step c), the transfer substrate (250) is brought above the chips (200), with its connection surface facing the connection surfaces of the chips, to simultaneously collect a plurality of chips at the pitch of the final display device.

8. The method of claim 7, wherein the support substrate (703; 803) comprises cavities (704; 804) having the chips (200) arranged therein so that the chips are laterally held by the cavity walls.

9. The method of claim 8, wherein the bottom of each cavity (804) of the support substrate (803) is non-planar.

10. The method according to any of claims 1 to 9, wherein, at step c), said direct bonding is performed at ambient temperature and pressure.
